# EUROPÄISCHE PATENTSCHRIFT

(11) **EP 1 142 039 B1**
(45) Veröffentlichungstag und Bekanntmachung des Hinweises auf die Patenterteilung: **24.03.2004**
(21) Anmeldenummer: 99950704.9
(22) Anmeldetag: 12.10.1999
(51) Int. Cl.: H01L 41/083, H01L 41/09

(54) **PIEZOAKTUATORISCHES KIPPELEMENT**
PIEZO-ELECTRIC TILTING ELEMENT
ELEMENT BASCULANT PIEZOELECTRIQUE

(30) Priorität: 30.11.1998 DE 19855221
(43) Veröffentlichungstag der Anmeldung: 10.10.2001
(73) Patentinhaber: MARCO SYSTEMANALYSE UND ENTWICKLUNG GmbH, D-85221 Dachau (DE)
(72) Erfinder: REUTER, Martin, D-85221 Dachau (DE)
(74) Vertreter: Manitz, Finsterwald & Partner GbR
(86) Internationale Anmeldenummer: PCT/EP1999/007629
(87) Internationale Veröffentlichungsnummer: WO 2000/033395

(56) Entgegenhaltungen:
- EP-A- 0 143 128
- US-A- 5 073 740
- US-A- 5 153 477
- PATENT ABSTRACTS OF JAPAN vol. 012, no. 169 (M-699), 20. Mai 1988 (1988-05-20) & JP 62 283274 A (KOGANEI SEISAKUSHO:KK), 9. Dezember 1987 (1987-12-09)

## Beschreibung

Die vorliegende Erfindung betrifft ein piezoaktuatorisches Kippelement, das aus stapelförmig angeordneten und beidseitig mit jeweils einer Elektrode versehenen Schichten aus einem piezoelektrischen Material besteht, wobei die Elektroden durch durchgängige Kontaktierungen miteinander verbunden sind und wobei ein piezoelektrisch passiver Bereich vorgesehen ist, in dem in den kontaktierten Schichten kein elektrisches Feld entsteht, wobei die Kontaktierungen weitgehend in Richtung dieses feldfreien Bereiches verlagert sind.

Ein derartiges Kippelement ist aus der DE 196 46 511 C1 bekannt. Dieses bekannte Kippelement arbeitet nach dem Doppelstapelprinzip, d.h. es sind mindestens zwei piezoelektrisch aktive Bereiche neben dem piezoelektrisch passiven Bereich vorgesehen, wobei die passiven Bereiche mit dem aktiven Bereich zumindest formschlüssig verbunden sind.

Das bekannte Kippelement hat sich in der Praxis bewährt, weist jedoch für bestimmte Anwendungsfälle Nachteile auf. Da bei der Doppelstapelanwendung beide Teilstapel antiparallel angeregt werden müssen, um ein Verkippen zu bewirken, entstehen grundsätzlich Probleme aufgrund der Tatsache, daß die meisten piezoelektrischen Keramikmaterialien depolarisiert werden können, wenn die Anregungsspannung entgegen der Polarisationsrichtung einen bestimmten Grenzwert überschreitet. Aus diesem Grund ist es erforderlich, bei den bekannten Kippelementen mit einer positiven Vorspannung für beide Teilstapel zu arbeiten, so daß eine Spannungsbeaufschlagung entgegen der Polarisationsrichtung nicht oder nur in geringem Maße erforderlich ist. Das bekannte Kippelement wird deshalb auch in seiner Nullstellung (Kippwinkel 0°)stets mit einer Vorspannung beaufschlagt.

Es ist die Aufgabe der vorliegenden Erfindung, ein piezoaktuatorisches Kippelement zu schaffen, das einfach zu fertigen ist, eine hohe Standzeit aufweist und in seiner Nullstellung spannungsfrei betrieben werden kann.

Die Lösung dieser Aufgabe erfolgt bei einem piezoaktuatorischen Kippelement nach dem Oberbegriff des Anspruchs 1 dadurch, daß nur ein einziger piezoelektrisch aktiver Bereich vorgesehen ist.

Die Erfindung beruht auf der Erkenntnis, daß ein - an sich bekannter - Einzelstapel zu einem piezoelektrischen Kippelement mit hoher Standzeit umgewandelt werden kann, wenn nur ein einziger piezoelektrisch aktiver Bereich vorgesehen wird und die Kontaktierungen weitgehend in Richtung eines feldfreien Bereiches verlagert sind. Mit der erfindungsgemäß vorgeschlagenen Anordnung ist es möglich, auch ohne Verwendung des Doppelstapelprinzips eine Kippbewegung bei Anregen des Kippelementes zu erzielen, wobei bei halbiertem Bauvolumen aufgrund der nicht mehr erforderlichen elektrischen Vorspannung der doppelte Kippwinkel erzielbar ist.

Das erfindungsgemäße Kippelement muß nicht antisymmetrisch angesteuert werden, ist sehr einfach zu fertigen und läßt sich insbesondere bei Anwendungen vorteilhaft einsetzen, bei denen ein minimaler Einbauraum zur Verfügung steht.

Vorteilhafte Ausführungsformen der Erfindung sind in der Beschreibung, den Figuren sowie den Unteransprüchen beschrieben.

Nach einer ersten vorteilhaften Ausführungsform können die Elektroden so gestaltet sein, daß die elektrische Feldstärke pro Flächeneinheit innerhalb einer Schicht in einer einzigen Richtung abnimmt oder in mindestens zwei zueinander im wesentlichen gleichsinnig parallelen Richtungen abnimmt. Bei dieser Ausführungsform läßt sich die elektrische Feldstärke in einem Übergangsbereich zwischen dem piezoelektrisch aktiven und dem piezoelektrisch passiven Bereich kontinuierlich oder stufenweise verändern, so daß das Ausdehnungs- bzw. Kippverhalten des Kippelementes beeinflußt werden kann.

Die Elektroden der Schichten können so gestaltet sein, daß die elektrische Feldstärke innerhalb einer Schicht in Richtung der Kontaktierungen einen Feldgradienten aufweist, so daß keine ungewünschten Feldstärkesprünge vorhanden sind.

Nach einer weiteren Ausbildung der Erfindung kann sich der feldfreie Bereich über die Elektroden hinaus erstrecken, was beispielsweise den Einbau des Kippelementes in ein Gehäuse oder in eine Einspannvorrichtung erleichtert. Hierbei ist es bevorzugt, daß das Kippelement insbesondere im Bereich der Kontaktierungen mechanisch vorgespannt ist, da hierdurch der Kippwinkel weiter vergrößert werden kann und unerwünschte Zugspannungen vermieden werden.

Es ist auch vorteilhaft, wenn das Kippelement mit einem Hebel versehen ist, der die Kippbewegung in eine Stellbewegung umwandelt, die im wesentlichen quer zur Längserstreckung des Stapels verläuft. Bei dieser Ausführungsform treten bei einer thermischen Längenänderung des Kippelementes keine Hubänderungen auf, da der vom Kippelement erzeugte Hub quer zur Längenänderung des Stapels verläuft.

Nach einer weiteren vorteilhaften Ausführungsform ist das Kippelement in einem Joch eingespannt und/oder zumindest einseitig durch eine Stütze abgestützt, was ein Vorspannen des Kippelementes unter Gewährleistung der Kippbewegungen erleichtert. Vorzugsweise ist die Stütze in einem Übergangsbereich zwischen piezoelektrisch aktivem und passivem Bereich oder hinter dem passiven Bereich an dem Kippelement angeordnet. Eine solche Anordnung hat sich bei ersten Testversuchen bewährt.

Besonders vorteilhaft ist es, wenn das Kippelement in einem U-förmigen Joch eingespannt ist. In diesem Fall kann der piezoelektrisch aktive Bereich zur offenen Seite des U hin angeordnet werden, wodurch der Wirkungsgrad des Kippelementes deutlich verbessert wird. Grundsätzlich kann die Einspannung durch das Joch ausreichend sein. Es kann jedoch auch vorteilhaft sein, zusätzliche Vorspanneinrichtungen vorzusehen, um mechanisches Spiel auszuschließen und um unerwünschte Zugspannungen während des Betriebs zu vermeiden.

Besonders vorteilhaft ist es, wenn das Joch eine Stütze aufweist, die mit einem Gelenk versehen ist, da hierdurch der Wirkungsgrad des Kippelementes deutlich erhöht werden kann. Bevorzugt ist das Gelenk etwa in der Mitte der Stütze angeordnet, wobei die Stütze hinter dem piezoelektrisch passiven Bereich oder zu beiden Seiten des piezoelektrischen passiven Bereiches angeordnet sein kann.

Das Joch ist vorzugsweise einteilig ausgebildet, kann jedoch zur Erleichterung der Montage auch mehrteilig ausgebildet werden.

Besonders vorteilhaft ist es, wenn die Kontaktierungen an der rückwärtigen Stirnseite des Stapels angeordnet werden, da diese Stirnseite bei dem Kippelement keinerlei Längungen bzw. Verkürzungen erfährt, so daß eine besonders hohe Standzeit der Kontaktierungen sichergestellt ist.

Nachfolgend wird die vorliegende Erfindung rein beispielhaft anhand vorteilhafter Ausführungsformen und unter Bezugnahme auf die beigefügten Zeichnungen beschrieben.

Es zeigen:
- Fig. 1: eine teilweise geschnittene Seitenansicht eines Kippelementes gemäß der Erfindung;
- Fig. 2: einen Teilquerschnitt durch das Kippelement von Fig. 1;
- Fig. 3: ein weiteres Kippelement gemäß der Erfindung; und
- Fig. 4: ein in ein Ventilgehäuse eingebautes Kippelement gemäß der Erfindung.

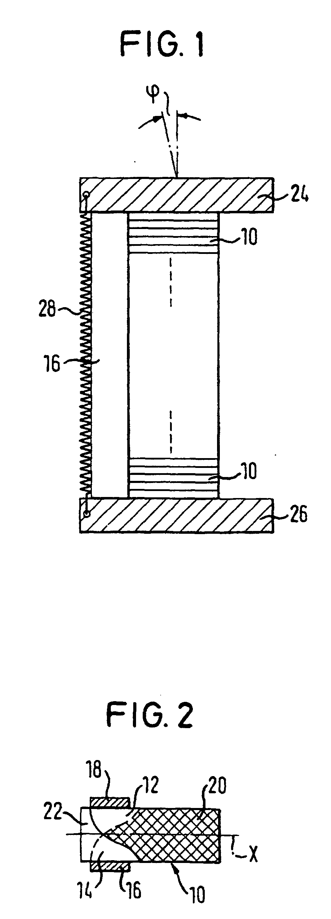

Fig. 1 zeigt ein piezoaktuatorisches Kippelement, das aus stapelförmig angeordneten Schichten 10 aus einem piezoelektrischen Material, beispielsweise piezokeramischen Folien besteht. Jeweils auf der Oberseite und der Unterseite jeder Schicht 10 sind Elektroden 12, 14 vorgesehen, die beispielsweise durch Sputtern aufgebracht werden und die durch durchgängige Kontaktierungen 16, 18 miteinander verbunden sind.

Fig. 2 zeigt eine Draufsicht auf eine Schicht 10, wobei zu erkennen ist, daß die obere Elektrode 12 nicht ganzflächig aufgebracht ist, sondern bezogen auf eine Symmetrielinie X etwa S-förmig endet. Die an der Unterseite der Schicht 10 vorgesehene Elektrode 14 ist bezogen auf die Symmetrielinie X spiegelverkehrt angebracht, so daß zwischen den Elektroden 12 und 14 ein piezoelektrisch aktiver Bereich 20 entsteht, der in Fig. 2 mit einer Doppelschraffur gekennzeichnet ist. Der in Fig. 2 nicht schraffierte Bereich ist piezoelektrisch passiv und die durchgängigen Kontaktierungen 16, 18 sind in Richtung dieses feldfreien Bereiches 22 verlagert. Wie Fig. 2 zeigt, nimmt die elektrische Feldstärke der Schicht 20 pro Flächeneinheit in einer einzigen Richtung ab, nämlich in einer Richtung, die zwischen die beiden Kontaktierungen 16, 18 weist. Auch erstreckt sich der feldfreie und somit piezoelektrisch passive Bereich 22 über die Kontaktierungen hinaus.

Fig. 1 zeigt, daß der aus den einzelnen Schichten 10 gebildete Stapel zwischen zwei Spannelemente 24, 26 eingesetzt ist, die über eine Spanneinrichtung 28 miteinander mechanisch vorgespannt sind. Bei Anlegen einer elektrischen Spannung an die Kontaktierungen 16, 18 verkippt der Stapel 10 um einen Winkel ϕ (Fig. 1), wodurch entsprechende Stellbewegungen übertragen werden können.

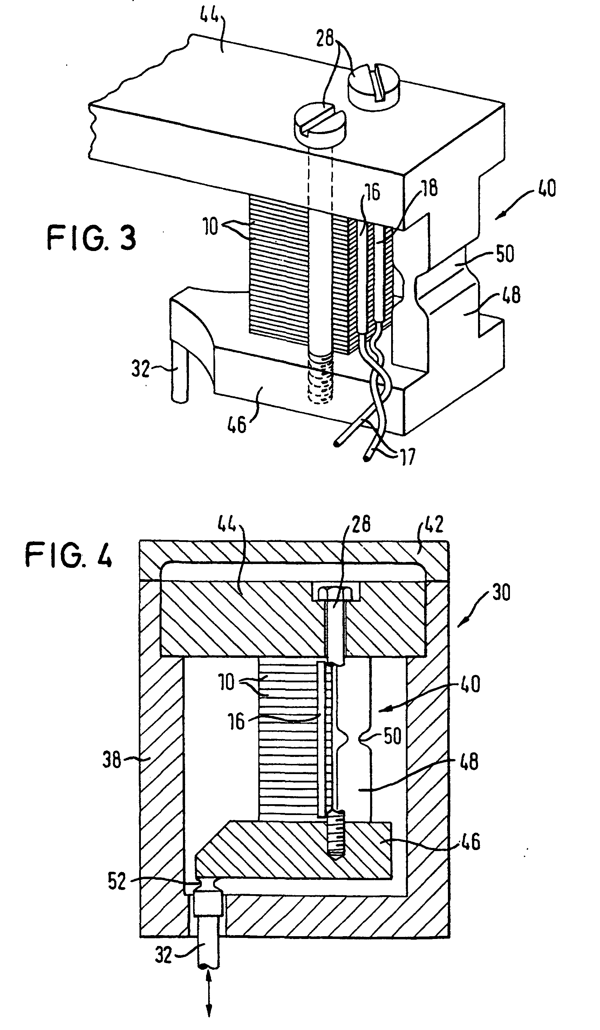

Fig. 3 zeigt eine weitere Ausführungsform eines Kippelementes, wobei der Stapel aus piezoelektrischen Schichten in einem Joch 40 angeordnet ist, das aus einer oberen Platte 44, einer unteren Platte 46 und einer Stütze 48 besteht, die einstückig miteinander verbunden sind und grundsätzlich die Form eines U aufweisen. Die Stütze 48 bildet die Basis des U und weist etwa in ihrer Mitte ein Gelenk 50 auf, das durch Materialverjüngungen gebildet ist.

Der Stapel aus piezoelektrischen Schichten 10 weist an seiner rückwärtigen Stirnseite zwei Kontaktierungen 16 und 18 auf, die mit den Elektroden der Schichten 10 leitend verbunden sind. Die Kontaktierungen 16 und 18 sind wiederum in Richtung des feldfreien Bereiches des piezoelektrischen Elementes verlagert. Zuleitungen 17 sind mit den Kontaktierungen 16 und 18 verbunden.

Als Vorspannelemente dienen zwei Schrauben 28, die durch die obere Platte 44 gesteckt und in der unteren Platte 46 verschraubt sind. Die beiden Schraubbolzen 28 befinden sich etwa auf der Höhe der Kontaktierungen 16 und 18.

Die untere Platte 46 des Joches 40 ist an ihrem vorderen Ende verjüngt ausgebildet, wobei an der Unterseite des verjüngten Endes ein Stößel 32 gelenkig angebracht ist, der zum Öffnen und Schließen einer nicht dargestellten Ventilöffnung vorgesehen ist.

Fig. 4 zeigt ein Kippelement, das in ein Ventilgehäuse 30 eingebaut ist und zur Betätigung eines Stößels 32 dient, durch den ein nicht näher dargestellter Durchströmungskanal geöffnet wird. Das Ventilgehäuse 30 besteht. aus einem Grundkörper 38, auf den ein Deckel 42 aufgesetzt ist.

Innerhalb des Ventilgehäuses 30 befindet sich unter Vorspannung ein Kippelement, wie es im Zusammenhang mit den Fig. 1 und 2 beschrieben ist, das wiederum aus einzelnen mit Elektroden versehenen Schichten 10 besteht, die durch durchgängige Kontaktierungen 16 (18 ist nicht erkennbar) miteinander verbunden sind. Der Stapel ist in einem U-förmigen Joch 40 eingespannt, das aus einer oberen Platte 44, einer unteren Platte 46 und einer Stütze 48 besteht, die einstückig miteinander verbunden sind.

Die obere Platte 44 des Joches 40 ist in dem Gehäuse 38 abgestützt und die untere Platte 46 ist mit einem Abstand zu dem Gehäuseboden angeordnet. Der Stapel aus piezoelektrischem Material befindet sich innerhalb des Joches 40, wobei der piezoelektrisch passive Bereich benachbart und beabstandet zu der Stütze 48 angeordnet ist. Die Stütze 48 weist etwa in ihrer Mitte ein Gelenk 50 auf, das durch eine Materialverjüngung gebildet ist.

Zwei Spannschrauben 28 sind durch die obere Platte 44 gesteckt und in der unteren Platte 46 des Joches 40 verschraubt. Die Spannschrauben befinden sich dabei im wesentlichen zwischen den Kontaktierungen 16 und der Stütze 48.

Der Stößel 32 ist über ein weiteres Gelenk 52 mit der Unterseite der unteren Platte 46 an deren vorderem Ende verbunden.

Bei Anlegen einer Wechselspannung an die Kontaktierungen 16, 18 des Kippelementes, die im Hochfrequenzbereich liegen kann, führt der Stapel aus piezoelektrischem Material eine Kippbewegung aus, so daß die untere Platte 46 gegenüber der oberen Platte 44 verkippt wird und dadurch den Stößel 32 nach oben und nach unten bewegt.

An dieser Stelle sei bemerkt, daß die konkrete Ausgestaltung des Jochs 40 bzw. der Stütze 48 nur beispielhaft ist, und daß die Geometrien je nach Anwendungsfall angepaßt werden können. Die Stütze 48 und/oder das Joch 40 können vorzugsweise aus Al₂O₃ oder einem anderen Material hergestellt sein, dessen thermische Längenänderung der des piezoelektrischen Materials ähnlich ist, wodurch thermische Längenänderungen minimiert sind.

## Patentansprüche

1. Piezoaktuatorisches Kippelement bestehend aus stapelförmig angeordneten und beidseitig mit jeweils einer Elektrode versehenen Schichten (10) aus einem piezoelektrischen Material, wobei die Elektroden (12, 14) durch durchgängige Kontaktierungen (16, 18) miteinander verbunden sind und ein piezoelektrisch passiver Bereich (22) vorgesehen ist, in dem in den Schichten kein elektrisches Feld entsteht, wobei die Kontaktierungen (16, 18) weitgehend in Richtung dieses feldfreien Bereiches (22) verlagert sind,
**dadurch gekennzeichnet, daß**
nur ein einziger piezoelektrisch aktiver Bereich (20) vorgesehen ist in dem in den Schichten ein elektrisches Feld entsteht.

2. Kippelement nach Anspruch 1,
**dadurch gekennzeichnet, daß**
die Elektroden (12, 14) so gestaltet sind, daß die elektrische Feldstärke pro Flächeneinheit innerhalb einer Schicht (10) in einer einzigen Richtung abnimmt oder in mindestens zwei zueinander im wesentlichen gleichsinnig parallelen Richtungen abnimmt.

3. Kippelement nach Anspruch 1,
**dadurch gekennzeichnet, daß**
die Elektroden (12, 14) so gestaltet sind, daß die elektrische Feldstärke innerhalb einer Schicht (10) in Richtung der Kontaktierungen (16, 18) einen Feldgradienten aufweist.

4. Kippelement nach Anspruch 1,
**dadurch gekennzeichnet, daß**
sich der feldfreie Bereich (22) über die Kontaktierungen (16, 18) hinaus erstreckt.

5. Kippelement nach Anspruch 1,
**dadurch gekennzeichnet, daß**
dieses insbesondere im Bereich der Kontaktierungen (16, 18) mechanisch vorgespannt ist, insbesondere in einem U-förmigen Joch (40) eingespannt ist, das mehrteilig ausgebildet sein kann.

6. Kippelement nach Anspruch 1,
**dadurch gekennzeichnet, daß**
dieses mit einem Hebel versehen ist, der die Kippbewegung in eine Stellbewegung umwandelt, die im wesentlichen quer zur Längserstreckung des Stapels verläuft.

7. Kippelement nach Anspruch 5,
**dadurch gekennzeichnet, daß**
das Joch (40) eine sich im wesentlichen parallel zu dem Stapel erstreckende Stütze (48) aufweist, die vorzugsweise mit einem Gelenk (50) versehen ist, das insbesondere durch eine Materialverjüngung gebildet ist, wobei das Gelenk (50) etwa in der Mitte der Stütze (48) angeordnet sein kann.

8. Kippelement nach einem der Ansprüche 5-7,
**dadurch gekennzeichnet, daß**
der Stapel der piezoelektrischen Schichten (10) zu der Stütze (50) des Jochs (40) beabstandet ist und daß eine Vorspanneinrichtung (28) im Bereich dieses Abstandes angeordnet ist.

9. Kippelement nach Anspruch 1,
**dadurch gekennzeichnet, daß**
dieses vorzugsweise über mindestens ein Gelenk (52) mit einem Ventilstößel (32) in Wirkverbindung steht.

10. Kippelement nach Anspruch 1,
**dadurch gekennzeichnet, daß**
alle Kontaktierungen (16, 18) an der rückwärtigen Stirnseite des Stapels aus piezoelektrischen Schichten angeordnet sind.

## Claims

1. A tilting element in the form of a piezoelectric actuator comprising piezoelectric layers (10) of a piezoelectric material arranged in the form of a stack and having an electrode at each side, with the electrodes (12, 14) being connected to one another by throughgoing contacts (16, 18) and a piezoelectrically passive region (22) being provided in which no electric field is generated in the layers, with the contacts (16, 18) being largely transposed in the direction of this field-free region (22), **characterized in that** only one single piezoelectrically active region (20) is provided in which an electrical field develops in the layers.

2. A tilting element in accordance with claim 1, **characterized in that** the electrodes (12, 14) are designed such that the electrical field strength per unit of area in a layer (10) decreases in one single direction or in at least two directions that are substantially equidirectionally parallel.

3. A tilting element in accordance with claim 1, **characterized in that** the electrodes (12, 14) are designed such that the electrical field strength inside a layer (10) has a field gradient in the direction of the contacts (16, 18).

4. A tilting element in accordance with claim 1, **characterized in that** the field-free region (22) extends beyond the contacts (16, 18).

5. A tilting element in accordance with claim 1, **characterized in that** this is mechanically pre-stressed, particularly in the region of the contacts (16, 18), particularly clamped in a U-shaped yoke (40) which can be made of several parts.

6. A tilting element in accordance with claim 1, **characterized in that** this is provided with a lever which converts the tilting motion into a positioning motion which extends substantially transversely to the longitudinal extent of the stack.

7. A tilting element in accordance with claim 5, **characterized in that** the yoke (40) has a brace (48) which is substantially parallel to the stack and which is preferably provided with a hinge (50) which is made in particular by a narrowing of the material, wherein the hinge (50) may be arranged approximately at the center of the brace (48).

8. A tilting element in accordance with any one of claims 5-7, **characterized in that** the stack of the piezoelectric layers (10) is spaced from the brace (50) of the yoke (40) and **in that** a pre-stressing device (28) is arranged in the region of this spacing.

9. A tilting element in accordance with claim 1, **characterized in that** this cooperates with a valve tappet (32) preferably via at least one joint (52).

10. A tilting element in accordance with claim 1, **characterized in that** all contacts (16, 18) are arranged at the rear face of the stack of piezoelectric layers.

## Revendications

1. Élément basculant actionneur piézo-électrique, constitué de couches (10) en matériau piézo-électrique, agencées en formant un empilement et dotées chacune d'électrodes sur les deux côtés, lesdites électrodes (12, 14) étant reliées les unes aux autres par des moyens de mise en contact (16, 18) continus, et il est prévu une zone passive (22) sur le plan piézo-électrique, dans laquelle n'apparaît aucun champ électrique dans les couches, lesdits moyens de mise en contact (16, 18) étant déportés largement en direction de cette zone (22) dépourvue de champ, **caractérisé en ce qu'**il n'est prévu qu'une seule zone (20) active sur le plan piézo-électrique, dans laquelle apparaît un champ électrique dans les couches.

2. Élément basculant selon la revendication 1, **caractérisé en ce que** les électrodes (12, 14) sont ainsi réalisées que l'intensité du champ électrique par unité de surface à l'intérieur d'une couche (10) diminue dans une direction unique, ou diminue dans au moins deux directions parallèles et sensiblement dans le même sens l'une par rapport à l'autre.

3. Élément basculant selon la revendication 1, **caractérisé en ce que** les électrodes (12, 14) sont ainsi réalisées que l'intensité du champ électrique présente un gradient de champ à l'intérieur d'une couche (10) en direction des moyens de mise en contact (16, 18).

4. Élément basculant selon la revendication 1, **caractérisé en ce que** la zone (22) dépourvue de champ s'étend au-delà des moyens de mise en contact (16, 18).

5. Élément basculant selon la revendication 1, **caractérisé en ce que** celui-ci est précontraint de façon mécanique, en particulier dans la zone des moyens de mise en contact (16, 18), en étant en particulier serré dans une culasse (40) en forme de U, laquelle peut être réalisée en plusieurs pièces.

6. Élément basculant selon la revendication 1, **caractérisé en ce que** celui-ci est pourvu d'un levier qui convertit le mouvement de basculement en un mouvement de positionnement qui s'étend essentiellement perpendiculairement à l'extension longitudinale de l'empilement.

7. Élément basculant selon la revendication 5, **caractérisé en ce que** la culasse (40) comprend un montant (48) qui s'étend sensiblement parallèlement à l'empilement et qui est de préférence pourvu d'une articulation (50), ladite articulation étant en particulier formée par un rétrécissement de matériau, et ladite articulation (50) pouvant être agencée approximativement au milieu du montant (48).

8. Élément basculant selon l'une des revendications 5 à 7, **caractérisé en ce que** l'empilement des couches piézo-électriques (10) est disposé écarté du montant (48) de la culasse (40), et **en ce qu'**un dispositif (28) de précontrainte est agencé dans la zone de cet écartement.

9. Élément basculant selon la revendication 1, **caractérisé en ce que** celui-ci est en coopération d'action avec un poussoir de valve (32), de préférence via au moins une articulation (52).

10. Élément basculant selon la revendication 1, **caractérisé en ce que** tous les moyens de mise en contact (16, 18) sont agencés sur le côté postérieur de l'empilement de couches piézo-électriques.
